# NEUE EUROPÄISCHE PATENTSCHRIFT

(11) **EP 1 671 379 B2**
(45) Veröffentlichungstag und Bekanntmachung des Hinweises auf die Entscheidung über den Einspruch: **01.10.2014**
(45) Hinweis auf die Patenterteilung: 22.12.2010
(21) Anmeldenummer: 04764853.0
(22) Anmeldetag: 04.09.2004
(51) Int. Cl.: H01L 51/30

(54) **ELEKTRONISCHE VORRICHTUNG ENTHALTEND EINEN ORGANISCHEN LEITER UND EINEN ORGANISCHEN HALBLEITER UND DAZWISCHEN EINE PUFFERSCHICHT BESTEHEND AUS EINEM POLYMER WELCHES KATIONISCH POLYMERISIERBAR IST**
ELECTRONIC DEVICE COMPRISING AN ORGANIC SEMICONDUCTOR, AN ORGANIC SEMICONDUCTOR, AND AN INTERMEDIATE BUFFER LAYER MADE OF A POLYMER THAT IS CATIONICALLY POLYMERIZABLE
DISPOSITIF ELECTRONIQUE CONTENANT UN CONDUCTEUR ORGANIQUE ET UN SEMI-CONDUCTEUR ORGANIQUE, ET ENTRE LES DEUX UNE COUCHE TAMPON CONSTITUEE D'UN POLYMERE POUVANT ETRE POLYMERISE DE MANIERE CATIONIQUE

(30) Priorität: 04.09.2003 DE 10340711
(43) Veröffentlichungstag der Anmeldung: 21.06.2006
(73) Patentinhaber: Merck Patent GmbH, 64293 Darmstadt (DE)
(72) Erfinder: PARHAM, Amir, 65929 Frankfurt (DE); Ludemann, Aurélie, 60322 Frankfurt (DE); HEUN, Susanne, 65812 Bad Soden (DE); STEIGER, Jürgen, 40237 Düsseldorf (DE); MÜLLER, David Christoph, 80339 München (DE); MEERHOLZ, Klaus, 51503 Rösrath (DE)
(86) Internationale Anmeldenummer: PCT/EP2004/009902
(87) Internationale Veröffentlichungsnummer: WO 2005/024970

(56) Entgegenhaltungen:
- EP-A- 0 637 899
- WO-A-02/10129
- WO-A-02/21611
- WO-A2-02/10129
- WO-A2-2004/023573
- WO-A2-2004/100282
- JP-A- 09 255 774
- JP-A- 2003 221 447
- US-A- 5 929 194
- US-A- 6 107 452
- CHANG S-C ET AL: "MULTICOLOR ORGANIC LIGHT-EMITTING DIODES PROCESSED BY HYBRID INKJETPRINTING" ADVANCED MATERIALS, VCH VERLAGSGESELLSCHAFT, WEINHEIM, DE, Bd. 11, Nr. 9, 5. Juli 1999 (1999-07-05), Seiten 734-737, XP000851832 ISSN: 0935-9648
- BRAIG T: "Crosslinkable hole-transporting polymers by palladium catalyzed C-N-coupling reaction" MACROMOLECULAR: RAPID COMMUNICATIONS, WILEY VCH, WEINHEIM, DE, Bd. 21, Nr. 9, Juni 2000 (2000-06), Seiten 583-589, XP002193425 ISSN: 1022-1336
- J.V. CRIVELLO, J.H.W. LAM: "Complex Triarylsulfonium Salt Photoinitiators. II. The Preparation of Several New Complex Triarylsulfonium Salts and the Influence of Their Structure in Photoinitiated Cationic Polymerization" JOURNAL OF POLYMER SCIENCE, POLYMER CHEMISTRY EDITION, Bd. 18, 1980, Seiten 2697-2714, XP002305902
- D. C. MÜLLER ET AL.: 'Efficient Blue Organic Light-Emitting Diodes with Graded Hole-Transport Layers**' CHEMPHYSCHEM Nr. 4, 2000, Seiten 207 - 211
- S. W. KIM ET AL.: 'Synthesis and properties of novel triphenylamine polymers containing ethynyl and aromatic moieties' SYNTHETIC METALS Bd. 122, 2001, Seiten 363 - 368
- D. MÜLLER ET AL.: 'Novel cross-linkable hole-transport monomer for use in organic light emitting diodes' SYNTHETIC METALS Bd. 111, Nr. 112, 2000, Seiten 31 - 34

## Beschreibung

Elektronische Vorrichtungen, welche organische, metallorganische oder polymere Halbleiter, bzw. auch Verbindungen aus verschiedenen dieser drei Gruppen enthalten, werden immer häufiger in kommerziellen Produkten verwendet oder stehen kurz vor der Markteinführung. Als Beispiele für bereits kommerzielle Produkte seien hier Ladungstransportmaterialien auf organischer Basis (i. d. R. Lochtransporter auf Triarylaminbasis) in Kopiergeräten und organische oder polymere Leuchtdioden (OLEDs oder PLEDs) in Anzeige- oder Display-Vorrichtungen genannt. Organische Solarzellen (O-SC), organische FeldeffektTransistoren (O-FET), organische Schaltelemente (O-IC) oder organische Laserdioden (O-Laser) sind in einem Forschungsstadium weit fortgeschritten und könnten in der Zukunft große Bedeutung erlangen.

Viele dieser Vorrichtungen weisen, unabhängig vom Verwendungszweck, folgenden allgemeinen Schichtaufbau auf, der für die einzelnen Anwendungen entsprechend angepasst wird:
(1) Substrat
(2) Kontaktierung: leitfähige Substanz, Elektrode; häufig metallisch oder anorganisch, aber auch aus organischen bzw. polymeren leitfähigen Materialien
(3) Eventuell Ladungsinjektionsschicht bzw. Zwischenschicht zum Ausgleich von Unebenheiten der Elektrode ("Planarisation Layer"), häufig aus einem leitfähigen, dotierten Polymer
(4) Organischer Halbleiter
(5) Eventuell Isolierschicht
(6) Zweite Kontaktierung: wie (2); zweite Elektrode, Materialien wie unter (2) genannt
(7) Verschaltung
(8) Verkapselung.

Ein Vorteil, den viele dieser organischen Vorrichtungen, v. a. solche, welche auf polymeren bzw. dendritischen oder oligomeren Halbleitern basieren, besitzen, ist, dass diese aus Lösung hergestellt werden können, was mit geringerem technischen und Kostenaufwand verbunden ist als Vakuumprozesse, wie sie im Allgemeinen für niedermolekulare Verbindungen durchgeführt werden. So können beispielsweise einfarbige elektrolumineszierende Vorrichtungen vergleichsweise einfach erzeugt werden, indem die Materialien durch Flächenbeschichtung aus Lösung (wie z. B. durch Spin-Coating, Rackel-Techniken, etc.) verarbeitet werden. Üblicherweise wird hier die Strukturierung, d. h. die Ansteuerung der einzelnen Bildpunkte, bei den "Zuleitungen", d. h. beispielsweise bei den Elektroden, durchgeführt. Dies kann z. B. durch Schattenmasken nach Art einer Schablone erfolgen. Ähnlich kann auch die Strukturierung organischer Schaltkreise und teilweise organischer Solarzellen-Panels bzw. Laser-Arrays erfolgen. Für die industrielle Massenfertigung ergeben sich hieraus jedoch deutliche Nachteile: Die Masken sind nach ein- oder mehrmaliger Benutzung unbrauchbar durch Belagbildung und müssen aufwändig regeneriert werden. Für die Produktion wäre es daher wünschenswert, einen Prozess zur Verfügung zu haben, für den keine Schattenmasken benötigt werden. Flächenbeschichtungen und Strukturierung durch Schattenmasken können außerdem nicht ohne Weiteres angewandt werden, wenn beispielsweise Vollfarbdisplays oder organische Schaltkreise mit unterschiedlichen Schaltelementen erzeugt werden sollen. Für Vollfarbdisplays müssen die drei Grundfarben (rot, grün, blau) in einzelnen Pixels (Bildpunkten) mit hoher Auflösung nebeneinander aufgebracht werden. Analoges gilt für elektronische Schaltkreise mit unterschiedlichen Schaltelementen. Während bei niedermolekularen aufdampfbaren Molekülen die einzelnen Bildpunkte durch das Aufdampfen der einzelnen Farben durch Schattenmasken erzeugt werden können (mit den oben bereits erwähnten damit verbundenen Schwierigkeiten), ist dies für polymere und aus Lösung verarbeitete Materialien nicht möglich, und die Strukturierung kann nicht mehr alleinig durch Strukturierung der Elektroden erfolgen. Hier besteht ein Ausweg darin, die aktive Schicht (beispielsweise: die Licht emittierende Schicht in OLEDs/PLEDs; Analoges gilt für Laser bzw. Ladungstransportschichten in allen Anwendungen) direkt strukturiert aufzubringen. Dass dies erhebliche Probleme bereitet, ist alleine schon aus den Dimensionen verständlich: Es müssen Strukturen im Bereich von einigen 10 µm bei Schichtdicken im Bereich von weniger als 100 nm bis zu wenigen µm geschaffen werden. In letzter Zeit wurden hierfür insbesondere verschiedene Drucktechniken in Erwägung gezogen, wie beispielsweise Tintenstrahldruck, OffSet-Druck, etc.. Jedoch hat jede dieser Drucktechniken ihre eigenen Probleme, und keine ist bislang soweit ausgereift, dass sie für einen Massenfertigungsprozess anwendbar wäre. Außerdem wird hier (im Bereich der OLEDs) für die Elektroden die oben bereits geschilderte Maskentechnologie verwendet. Diese bringt jedoch auch hier die oben geschilderten Probleme der Belagbildung mit sich. Deshalb muss die Strukturierbarkeit durch Drucktechniken derzeit noch als ungelöstes Problem angesehen werden.

Ein anderer Ansatz zur Strukturierbarkeit wurde in WO 02/10129 und Nature 2003, 421, 829 vorgeschlagen. Dort werden strukturierbare Materialien beschrieben, die zur Verwendung in strukturierten Vorrichtungen, wie OLEDs, PLEDs, organischen Lasern, organischen Schaltelementen oder organischen Solarzellen geeignet sind. Es handelt sich dabei um organische, insbesondere elektrolumineszierende Materialien, die mindestens eine zur Vernetzung befähigte Oxetangruppe enthalten, deren Vernetzungsreaktion gezielt ausgelöst und gesteuert werden kann. In Macromol. Rapid Commun. 1999, 20, 225 sind mit Oxetangruppen funktionalisierte N,N,N',N'-Tetraphenylbenzidine beschrieben, die photoinduziert vernetzbar sind. Diese Verbindungsklasse wird als strukturierbarer Lochleiter direkt auf der Anode der organischen elektronischen Vorrichtung eingesetzt. Dabei wird den Materialien zur Vernetzung mindestens ein Photoinitiator zugemischt. Durch Bestrahlung mit aktinischer Strahlung wird eine Säure erzeugt, die durch kationische, ringöffnende Polymerisation eine Vernetzungsreaktion auslöst. Durch strukturierte Bestrahlung kann so ein Muster von Bereichen mit vernetztem und Bereichen mit unvernetztem Material erhalten werden. Durch geeignete Operationen (z. B. Spülen mit geeigneten Lösemitteln) können dann die Bereiche mit unvernetztem Material entfernt werden. Dies führt zur gewünschten Strukturierung. So kann das nachfolgende Aufbringen der verschiedenen Schichten (bzw. anderer Materialien, die in Nachbarschaft zum ersten Material aufgebracht werden sollen) nach erfolgter Vernetzung durchgeführt werden. Die Bestrahlung, wie sie zur Strukturierung angewandt wird, ist ein Standardprozess der heutigen Elektronik und kann z. B. mit Lasern oder durch flächige Bestrahlung durch eine entsprechende Photomaske erfolgen. Diese Maske birgt hier keine Gefahr der Belegung, da hier ja nur Strahlung und kein Materialfluss durch die Maske zu verzeichnen ist. In ChemPhysChem 2000, 207 wird eine solche vernetzte Triarylamin-Schicht als Zwischenschicht zwischen einem leitfähigen dotierten Polymer und einem organischen lumineszierenden Halbleiter eingebracht. Dabei wird eine höhere Effizienz erhalten. Auch hier wird für die Vernetzung eine Photosäure verwendet. Dies scheint notwendig zu sein für die vollständige Vernetzung der Triarylaminschicht. Jedoch verbleiben die Photosäure bzw. deren Reaktionsprodukte nach der Vernetzung als Verunreinigung in der elektronischen Vorrichtung. Es ist allgemein anerkannt, dass sowohl organische wie auch anorganische Verunreinigungen den Betrieb organischer elektronischer Vorrichtungen stören können. Deshalb wäre es wünschenswert, die Verwendung der Photosäure weitestmöglich reduzieren zu können.

In EP 0637899 werden elektrolumineszierende Anordnungen mit ein oder mehreren Schichten vorgeschlagen, in denen mindestens eine Schicht durch thermische oder strahlungsinduzierte Vernetzung erhalten wird, die außerdem mindestens eine Emitterschicht enthalten und pro Schicht mindestens eine Ladungstransporteinheit. Dabei kann die Vernetzung radikalisch, anionisch, kationisch oder über eine photoinduzierte Ringschlussreaktion ablaufen. Als Vorteil wird genannt, dass dadurch mehrere Schichten übereinander aufgebaut werden können oder auch, dass die Schichten strahlungsinduziert strukturiert werden können. Es wird jedoch keine Lehre erteilt, durch welche der vielfältigen Vernetzungsreaktionen ein taugliches Device hergestellt werden kann und wie die Vernetzungsreaktion am besten durchgeführt wird. Es wird lediglich erwähnt, dass radikalisch vernetzbare Einheiten bzw. zur Photocycloaddition befähigte Gruppen bevorzugt sind, dass Hilfsstoffe verschiedener Art, beispielsweise Initiatoren, enthalten sein können und dass der Film bevorzugt mittels aktinischer Strahlung und nicht thermisch vernetzt wird. Auch geeignete Device-Konfigurationen sind nicht beschrieben. So ist nicht klar, wie viele Schichten das Device bevorzugt aufweist, wie dick diese sein sollen, welche Materialklassen bevorzugt verwendet werden und welche davon vernetzt werden sollen. Daher ist es auch für den Fachmann nicht offensichtlich, wie die beschriebene Erfindung erfolgreich in die Praxis umgesetzt werden kann.

In Vorrichtungen für die organische Elektronik wird häufig zwischen die Elektrode (insbesondere die Anode) und das Funktionsmaterial eine Zwischenschicht aus einem leitfähigen, dotierten Polymer als. Ladungsinjektionsschicht eingebracht (Appl. Phys. Lett. 1997, 70, 2067-2069). Alternativ kann auch ein leitfähiges, dotiertes Polymer direkt als Anode (oder je nach Anwendung auch als Kathode) verwendet werden. Die geläufigsten dieser Polymere sind Polythiophenderivate (z. B. Poly(ethylendioxythiophen), PEDOT) und Polyanilin (PANI), die in der Regel mit Polystryrolsulfonsäure oder anderen polymergebundenen Brönstedt-Säuren dotiert und so in einen leitfähigen Zustand gebracht werden. Ohne in der nachfolgenden Erfindung an die Richtigkeit dieser speziellen Theorie gebunden sein zu wollen, vermuten wir, dass aus den sauren Gruppen bei Betreiben der Vorrichtung Protonen oder andere Verunreinigungen in die funktionelle Schicht diffundieren, die im Verdacht stehen, dort die Funktionalität der Vorrichtung bedeutend zu stören. So wird vermutet, dass diese Verunreinigungen die Effizienz wie auch die Lebensdauer der Vorrichtungen reduzieren. Insbesondere negativ wirken sich Protonen oder sonstige kationische Verunreinigungen dann aus, wenn die auf diese Schicht aufgebrachte funktionelle Halbleiterschicht kationisch vernetzbar ist und, wie oben beschrieben, strukturiert werden soll. Wir vermuten, dass durch die Anwesenheit von Protonen oder anderen kationischen Verunreinigungen die funktionelle Schicht bereits teilweise oder vollständig vernetzt wird, ohne dass die Möglichkeit zur kontrollierten Vernetzung, beispielsweise durch aktinische Strahlung, gegeben ist. Damit geht der Vorteil der gezielten Strukturierbarkeit verloren. So bieten kationisch vernetzbare Materialien zwar prinzipiell die Möglichkeit zur Strukturierung und somit eine Alternative zu Drucktechniken. Jedoch ist die technische Anwendung dieser Materialien bislang nicht möglich, da das Problem der unkontrollierten Vernetzung auf einer dotierten Ladungsinjektionsschicht noch nicht gelöst ist.

Im Journal of Applied Physics (Vol. 94, Nr.5, 1.09.2003) werden elektrolumineszente Vorrichtungen offenbart, die eine Lochinjektionsschicht aus PEDOT/PSS, eine vernetzte Lochtransportschicht und eine polymere Emitterschicht aufweisen. Als vernetztbare Materialien für die Lochtransportschicht werden oligomere Triphenylamine offenbart mit vernetzbaren Styrylgruppen.

Überraschend wurde nun gefunden, dass die elektronischen Eigenschaften der Vorrichtungen deutlich verbessert werden können, wenn zwischen die dotierte Zwischenschicht und die funktionelle organische Halbleiterschicht mindestens eine Pufferschicht eingebracht wird, die kationisch vernetzbar ist. Besonders gute Eigenschaften werden bei einer Pufferschicht erhalten, deren kationische Vernetzung thermisch induziert wird, d. h. durch Temperaturerhöhung auf 50 bis 250°C, bevorzugt auf 80 bis 200 °C und der keine Photosäure zugesetzt wird. Ein weiterer Vorteil dieser Pufferschicht besteht darin, dass die nicht kontrollierbare Vernetzung eines kationisch vernetzbaren Halbleiters durch Verwendung der Pufferschicht vermieden werden kann und somit erst die gezielte Strukturierung des Halbleiters ermöglicht wird. Ein nochmals weiterer Vorteil der Vernetzung der Pufferschicht besteht darin, dass durch die Vernetzung die Glasübergangtemperatur des Materials und damit die Stabilität der Schicht erhöht wird.

Gegenstand der Erfindung sind daher elektronische Vorrichtungen wie in Anspruch 1 beschrieben.

Weiterhin bevorzugt ist eine organische Pufferschicht, deren Vernetzung in der entsprechenden Device-Anordnung thermisch, d. h. durch Temperaturerhöhung auf 80 - 200 °C, ohne Zusatz weiterer Hilfsstoffe, wie beispielsweise Photosäuren, induziert werden kann.

Eine Photosäure ist eine Verbindung, die bei Bestrahlung mit aktinischer Strahlung durch eine photochemische Reaktion eine protische Säure freisetzt. Beispiele für Photosäuren sind 4-(Thio-phenoxyphenyl)-diphenylsulfonium hexafluoroantimonat oder {4-[(2-Hydroxytetradecyl)-oxyl]-phenyl}-phenyliodonium hexafluoroantimonat und andere, wie beispielsweise in EP 1308781 beschrieben.

Elektronische Vorrichtungen im Sinne dieser Erfindung sind organische oder polymere Leuchtdioden (OLED, PLED, z. B. EP 0676461, WO 98/27136), organische Solarzellen (O-SC, z. B. WO 98/48433, WO 94/05045), organische Feld-Effekt-Transistoren (O-FET, z. B. US 5705826, US 5596208, WO 00/42668), Feld-Quench-Elemente (FQD, z. B. US 2004/017148), organische Schaltelemente (O-IC, z. B. WO 95/31833, WO 99/10939), organische optische Verstärker oder organische Laserdioden (O-Laser, z. B. WO 98/03566). Organisch im Sinne dieser Erfindung bedeutet, dass mindestens eine Schicht eines organischen leitfähigen dotierten Polymers, mindestens eine leitende oder halbleitende organische Pufferschicht und mindestens eine Schicht enthaltend mindestens einen organischen Halbleiter vorhanden sind; es können außer diesen auch weitere organische Schichten (beispielsweise Elektroden) vorhanden sein. Es können aber durchaus auch Schichten vorhanden sein, die nicht auf organischen Materialien basieren, wie beispielsweise anorganische Zwischenschichten oder Elektroden.

Die elektronische Vorrichtung ist im einfachsten Fall aufgebaut aus Substrat (üblicherweise Glas oder eine Kunststofffolie), Elektrode, Zwischenschicht aus einem leitfähigen, dotierten Polymer, erfindungsgemäße vernetzbare Pufferschicht, organischer Halbleiter und Gegenelektrode. Diese Vorrichtung wird entsprechend (je nach Anwendung) strukturiert, kontaktiert und hermetisch versiegelt, da sich die Lebensdauer derartiger Vorrichtungen bei Anwesenheit von Wasser und/oder Luft drastisch verkürzt. Dabei kann es auch bevorzugt sein, als Elektrodenmaterial für eine oder beide Elektroden ein leitfähiges, dotiertes Polymer zu verwenden und dann keine Zwischenschicht aus leitfähigem, dotiertem Polymer einzubringen. Für Anwendungen in O-FETs ist es außerdem nötig, dass der Aufbau außer Elektrode und Gegenelektrode (Source und Drain) noch eine weitere Elektrode (Gate) enthält, die durch eine Isolatorschicht mit einer in der Regel hohen Dielektrizitätskonstante vom organischen Halbleiter abgetrennt ist. Außerdem kann es sinnvoll sein, in die Vorrichtung noch weitere Schichten einzubringen.

Die Elektroden werden so gewählt, dass ihr Potenzial möglichst gut mit dem Potenzial der angrenzenden organischen Schicht übereinstimmt, um eine möglichst effiziente Elektronen- bzw. Lochinjektion zu gewährleisten. Soll die Kathode Elektronen injizieren, wie dies beispielsweise in OLEDs/PLEDs oder n-leitenden O-FETs der Fall ist, oder Löcher aufnehmen, wie dies beispielsweise in O-SCs der Fall ist, sind als Kathode Metalle mit geringer Austrittsarbeit, Metalllegierungen oder mehrlagige Strukturen mit verschiedenen Metallen bevorzugt, wie beispielsweise Erdalkalimetalle, Alkalimetalle, Hauptgruppenmetalle oder Lanthanide (z. B. Ca, Ba, Mg, Al, In, Mg, Yb, Sm, etc.). Bei mehrlagigen Strukturen können auch zusätzlich zu den vorgenannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Die Kathoden sind üblicherweise zwischen 10 und 10000 nm, bevorzugt zwischen 20 und 1000 nm, dick. Es kann auch bevorzugt sein, zwischen eine metallische Kathode und den organischen Halbleiter (bzw. andere funktionelle organische Schichten, die gegebenenfalls anwesend sind) eine dünne Zwischenschicht eines Materials mit einer hohen Dielektrizitätskonstanten einzubringen. Hierfür kommen beispielsweise Alkalimetall- oder Erdalkalimetallfluoride, aber auch die entsprechenden -oxide in Frage (z. B. LiF, Li₂O, BaF₂, MgO, NaF, etc.). Die Schichtdicke dieser dielektrischen Schicht beträgt bevorzugt zwischen 1 und 10 nm.

Als Anode sind Materialien mit hoher Austrittsarbeit bevorzugt, wenn an der Anode Löcher injiziert (wie beispielsweise in OLEDs/PLEDs, p-leitenden O-FETs) bzw. Elektronen aufgenommen (wie beispielsweise O-SCs) werden. Bevorzugt weist die Anode ein Potential größer 4.5 eV vs. Vakuum auf. Hierfür sind einerseits Metalle mit hohem Redoxpotenzial geeignet, wie beispielsweise Ag, Pt oder Au. Es können auch Metall/Metalloxid-Elektroden (z. B. Al/Ni/NiOₓ, Al/Pt/PtO_{X}) bevorzugt sein. Die Anode kann auch aus einem leitfähigen organischen Material (z. B. ein leitfähiges, dotiertes Polymer) bestehen.

Für einige Anwendungen muss mindestens eine der Elektroden transparent sein, um entweder die Bestrahlung des organischen Materials (O-SC) oder die Auskopplung von Licht (OLED/PLED, O-LASER, organischer optischer Verstärker) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere. Ein ähnlicher Aufbau gilt auch für invertierte Strukturen, bei denen das Licht aus der Kathode ausgekoppelt bzw. an der Kathode eingestrahlt wird. Die Kathode besteht dann bevorzugt aus den oben beschriebenen Materialien mit dem Unterschied, dass das Metall sehr dünn und damit transparent ist. Die Schichtdicke der Kathode liegt bevorzugt unter 50 nm, besonders bevorzugt unter 30 nm, insbesondere unter 10 nm. Darauf wird ein weiteres transparentes, leitfähiges Material aufgebracht, wie beispielsweise Indium-Zinn-Oxid (ITO), Indium-Zink-Oxid (IZO), etc..

Als leitfähiges, dotiertes Polymer (entweder als Elektrode oder als zusätzliche Ladungsinjektionsschicht oder "Planarisation Layer", um Unebenheiten der Elektrode auszugleichen und so Kurzschlüsse zu minimieren) kommen verschiedene organische, dotierte leitfähige Polymere in Frage. Bevorzugt sind hier Polymere, die je nach Anwendung eine Leitfähigkeit von > 10⁻⁸ S/cm aufweisen. In einer bevorzugten Ausführungsform dieser Erfindung ist das leitfähige, dotierte Polymer auf die Anode aufgebracht oder fungiert direkt als Anode. Hier beträgt das Potenzial der Schicht bevorzugt 4 bis 6 eV vs. Vakuum. Die Dicke der Schicht beträgt bevorzugt zwischen 10 und 500 nm, besonders bevorzugt zwischen 20 und 250 nm. Ist das leitfähige, dotierte Polymer selbst die Elektrode, sind die Schichten im Allgemeinen dicker, um eine gute elektrische Verbindung nach außen und einen geringen kapazitiven Widerstand zu gewährleisten. Besonders bevorzugt werden Derivate von Polythiophen (besonders bevorzugt Poly(ethylendioxythiophen), PEDOT) und Polyanilin (PANI) verwendet. Die Dotierung erfolgt in der Regel durch Säuren oder durch Oxidationsmittel. Bevorzugt erfolgt die Dotierung durch polymergebundene Brönsted-Säuren. Besonders bevorzugt sind hierfür allgemein polymergebundene Sulfonsäuren, insbesondere Poly(styrolsulfonsäure), Poly(vinylsulfonsäure) und PAMPSA (Poly(2-acrylamido-2-methyl-propansulfonsäure)). Das leitfähige Polymer wird in der Regel aus einer wässrigen Lösung oder Dispersion aufgetragen und ist unlöslich in organischen Lösungsmitteln. Dadurch kann die Folgeschicht aus organischen Lösungsmitteln problemlos aufgebracht werden.

Als organische Halbleiter kommen prinzipiell niedermolekulare, oligomere, dendritische oder polymere halbleitende Materialien in Frage. Unter einem organischen Material im Sinne dieser Erfindung sollen nicht nur rein organische Materialien, sondern auch metallorganische Materialien und Metallkoordinationsverbindungen mit organischen Liganden verstanden werden. Dabei können die oligomeren, dendritischen oder polymeren Materialien konjugiert, nicht-konjugiert oder auch teilkonjugiert sein. Konjugierte Polymere im Sinne dieser Erfindung sind Polymere, die in der Hauptkette hauptsächlich sp²-hybridisierte Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette beispielsweise Arylamineinheiten und/oder bestimmte Heterocyclen (d. h. Konjugation über N-, O- oder S-Atome) und/oder metallorganische Komplexe (d. h. Konjugation über das Metallatom) befinden. Hingegen würden Einheiten wie beispielsweise einfache Alkylenketten, (Thio)Etherbrücken, Ester-, Amid- oder Imidverknüpfungen eindeutig als nicht-konjugierte Segmente definiert. Außerdem sollen unter einem konjugierten organischen Material auch σ-konjugierte Polysilane, -germylene und Analoga verstanden werden, die organische Seitengruppen tragen und dadurch aus organischen Lösungsmitteln aufgebracht werden können, wie beispielsweise Poly(phenylmethylsilan). Nicht-konjugierte Materialien sind Materialien, in denen keine längeren konjugierten Einheiten in der Hauptkette bzw. im Dendrimergerüst auftreten. Unter teilkonjugierten Materialien sollen Materialien verstanden werden, die längere konjugierte Abschnitte in der Hauptkette bzw. im Dendrimergrundgerüst aufweisen, die durch nicht-konjugierte Einheiten überbrückt sind, oder die längere konjugierte Einheiten in der Seitenkette enthalten. Typische Vertreter konjugierter Polymere, wie sie beispielsweise in PLEDs oder O-SCs verwendet werden können, sind Poly-para-phenylenvinylene (PPV), Polyfluorene, Polyspirobifluorene oder Systeme, die im weitesten Sinne auf Poly-p-phenylen (PPP) basieren, und Derivate dieser Strukturen. Für die Verwendung in O-FETs sind vor allem Materialien mit hoher Ladungsträgermobilität von Interesse. Dies sind beispielsweise Oligo- oder Poly(triarylamine), Oligo- oder Poly(thiophene) und Copolymere, die einen hohen Anteil dieser Einheiten enthalten.
Die Schichtdicke des organischen Halbleiters beträgt je nach Anwendung bevorzugt 10 - 500 nm, besonders bevorzugt 20 - 250 nm.

Unter einem Dendrimer soll hier eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum, als auch die Monomere beliebige verzweigte Strukturen annehmen, die sowohl aus rein organischen Einheiten, als auch Organometallverbindungen oder Koordinationsverbindungen bestehen. Dendrimer soll hier allgemein so verstanden werden, wie dies beispielsweise in M. Fischer, F. Vögtle, Angew. Chem., Int. Ed. 1999, 38, 885-905 beschrieben ist.

Um mehrere organische Halbleiter aus Lösung übereinander aufbringen zu können, was für viele optoelektronische Anwendungen (z. B. PLEDs) von Vorteil ist, wurden vernetzbare organische Schichten entwickelt (WO 02/10129). Diese sind nach der Vernetzungsreaktion unlöslich und können daher durch Lösungsmittel beim Aufbringen weiterer Schichten nicht mehr angegriffen werden. Vernetzbare organische Halbleiter haben auch zur Strukturierung mehrfarbiger PLEDs Vorteile. Bevorzugt ist also weiterhin die Verwendung vernetzbarer organischer Halbleiter. Bevorzugte Vernetzungsreaktionen sind kationische Polymerisationen, basierend auf elektronenreichen Olefinderivaten, heteronuklearen Mehrfachbindungen mit Heteroatomen oder Heterogruppierungen oder Ringen mit Heteroatomen (z. B. O, S, N, P, Si, etc.). Besonders bevorzugte Vernetzungsreaktionen sind kationische Polymerisationen, basierend auf Ringen mit Heteroatomen. Solche Vernetzungsreaktionen sind unten für die erfindungsgemäße Pufferschicht ausführlich beschrieben.
Halbleitende lumineszierende Polymere, die chemisch vernetzt werden können, werden in WO 96/20253 allgemein offenbart. Als besonders geeignet haben sich Oxetan-haltige halbleitende Polymere erwiesen, wie in WO 02/10129 beschrieben. Diese können durch Zusatz einer Photosäure und Bestrahlung gezielt und kontrolliert vernetzt werden. Es kommen aber auch vernetzbare niedermolekulare Verbindungen in Frage, wie beispielsweise kationisch vernetzbare Triarylamine (M. S. Bayer et al., Macromol. Rapid Commun. 1999, 20, 224-228; D. C. Müller et al., ChemPhysChem 2000, 207-211).

Ohne an eine bestimmte Theorie gebunden sein zu wollen, vermuten wir, dass die in dem leitfähigen dotierten Polymer enthaltenen Protonen oder andere kationische Verunreinigungen bereits eine kationische Polymerisation auslösen können, wenn darauf ein kationisch vernetzbarer Halbleiter aufgebracht wird, und damit deren Strukturierung unmöglich machen. Aber auch Schichten organischer Halbleiter, die nicht kationisch vernetzbar sind, auf leitfähigen, dotierten Polymeren sind problematisch, da Verunreinigungen und deren Diffusion aus den dotierten Polymeren im Verdacht stehen, begrenzend für die Lebensdauer der elektronischen Vorrichtung zu sein. Außerdem ist die Lochinjektion aus dem dotierten Polymer in den organischen Halbleiter oft nicht zufriedenstellend.

Erfindungsgemäß ist daher die Einführung einer Pufferschicht, die zwischen das leitfähige, dotierte Polymer und den organischen Halbleiter eingebracht wird und die kationisch vernetzbare Einheiten trägt, wie in Anspruch 1 definiert so dass sie niedermolekulare, kationische Spezies sowie intrinsische kationische Ladungsträger aufnehmen kann, die aus dem leitfähigen, dotierten Polymer diffundieren können. Diese Pufferschicht kann vor der Vernetzung sowohl niedermolekular als auch oligomer, dendritisch oder polymer sein. Die Schichtdicke liegt bevorzugt im Bereich von 5 - 300 nm, besonders bevorzugt im Bereich von 10 - 200 nm. Bevorzugt liegt das Potenzial der Schicht zwischen dem Potenzial des leitfähigen, dotierten Polymers und dem des organischen Halbleiters. Dies kann erreicht werden durch geeignete Wahl der Materialien für die Pufferschicht sowie geeignete Substitution der Materialien.

Bevorzugte Materialien für die Pufferschicht leiten sich ab von lochleitenden Materialien, wie sie auch in anderen Anwendungen als Lochleiter verwendet werden. Besonders bevorzugt eignen sich hierfür kationisch vernetzbare Materialien auf Triarylamin-Basis, auf Thiophen-Basis, auf Triarylphosphin-Basis oder Kombinationen dieser Systeme. Auch Copolymere mit anderen Monomer-Einheiten, wie z. B. Fluoren, Spirobifluoren, etc., mit einem hohen Anteil dieser lochleitenden Einheiten sind geeignet. Durch geeignete Substitution können die. Potenziale dieser Verbindungen eingestellt werden. So erhält man durch Einführung elektronenziehender Substituenten (z. B. F, Cl, CN, etc.) Verbindungen mit einem niedrigeren HOMO (= höchstes besetztes Molekülorbital), während durch Einführung elektronenschiebender Substituenten (z. B. Alkoxygruppen, Aminogruppen, etc.) ein höheres HOMO erreicht wird.

Bei der erfindungsgemäßen Pufferschicht kann es sich um niedermolekulare Verbindungen handeln, die in der Schicht vernetzt und so unlöslich gemacht werden. Ebenfalls kommen oligomere, dendritische oder polymere lösliche Verbindungen in Frage, die durch anschließende kationische Vernetzung unlöslich gemacht werden. Weiterhin können Mischungen aus niedermolekularen Verbindungen und oligomeren, dendritischen und/oder polmyeren Verbindungen verwendet werden. Ohne bei dieser Erfindung an eine spezielle Theorie gebunden sein zu wollen, sind kationische Spezies, die aus dem leitfähigen, dotierten Polymer diffundieren können, an erster Stelle Protonen, die ursprünglich aus dem verwendeten Dotiermittel (häufig polymergebundene Sulfonsäuren) stammen können, aber auch aus ubiquitärem Wasser. Kationische Spezies, wie beispielsweise Metallionen, können auch als (ungewollte) Verunreinigungen im leitfähigen Polymer vorhanden sein. Eine weitere mögliche Quelle kationischer Spezies ist die Elektrode, auf die das leitfähige Polymer aufgetragen ist. So können beispielsweise aus einer ITO-Anode Indium-lonen austreten und in die aktiven Schichten des Devices diffundieren. Weitere, möglicherweise vorhandene, niedermolekulare kationische Spezies sind monomere oder oligomere Bestandteile des leitfähigen Polymers, die durch Protonierung oder andere Dotierung in einen kationischen Zustand überführt werden. Es ist weiterhin möglich, dass durch oxidative Dotierung eingebrachte Ladungsträger in die Halbleiterschicht diffundieren. Die kationisch vernetzbare Pufferschicht kann diffundierende kationische Spezies abfangen, wodurch nachfolgend die Vernetzungsreaktion initiiert wird; andererseits wird durch die Vernetzung gleichzeitig die Pufferschicht unlöslich gemacht, so dass das anschließende Auftragen eines organischen Halbleiters aus den üblichen organischen Lösemitteln keine Probleme bereitet. Die vernetzte Pufferschicht stellt eine weitere Barriere gegen Diffusion dar.

Erfindungsgemäß sind niedermolekulare, oligomere oder polymere organische Materialien, bei denen mindestens ein H-Atom durch eine Gruppe der Formel (I), Formel (II) oder Formel (III) ersetzt ist; 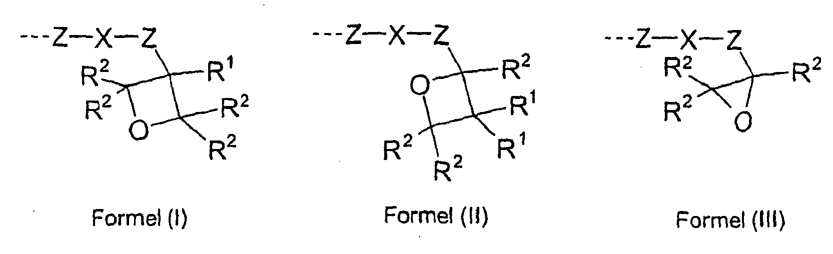 dabei gilt:
- R¹: ist bei jedem Auftreten gleich oder verschieden Wasserstoff, eine geradkettige, verzweigte oder cyclische Alkyl-, Alkoxy- oder Thioalkoxy- Gruppe mit 1 bis 20 C-Atomen, ein aromatisches oder heteroaromatisches Ringsystem mit 4 bis 24 aromatischen Ringatomen oder eine Alkenylgruppe mit 2 bis 10 C-Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R¹ miteinander bzw. mit R², R³ und/oder R⁴ ein mono- oder polycyclisches, aliphatisches oder aromatisches Ringsystem bilden;
- R²: ist bei jedem Auftreten gleich oder verschieden Wasserstoff, eine geradkettige, verzweigte oder cyclische Alkylgruppe mit 1 bis 20 C-Atomen, ein aromatisches oder heteroaromatisches Ringsystem mit 4 bis 24 aromatischen Ringatomen oder eine Alkenylgruppe mit 2 bis 10 C- Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R² miteinander bzw. mit R¹, R³ und/oder R⁴ ein mono- oder polycyclisches, aliphatisches oder aromatisches Ringsystem bilden;
- X: ist bei jedem Auftreten gleich oder verschieden -O-, -S-, -CO-, -COO-, -O-CO- oder eine bivalente Gruppe -(CR³R⁴)ₙ-;
- Z: ist bei jedem Auftreten gleich oder verschieden eine bivalente Gruppe -(CR³R⁴)ₙ-;
- R³, R⁴: ist bei jedem Auftreten gleich oder verschieden Wasserstoff, eine geradkettige, verzweigte oder cyclische Alkyl-, Alkoxy- oder Thioalkoxy- Gruppe mit 1 bis 20 C-Atomen, ein aromatisches oder heteroaromatisches Ringsystem mit 4 bis 24 aromatischen Ringatomen oder eine Alkenyl-Gruppe mit 2 bis 10 C-Atomen, bei denen ein oder mehrere Wasserstoffatome auch durch Halogen, wie Cl oder F, oder CN ersetzt sein können; dabei können auch zwei oder mehr Reste R³ bzw. R⁴ miteinander bzw. mit R¹ oder R² ein Ringsystem bilden;
- n: ist bei jedem Auftreten gleich oder verschieden eine ganze Zahl zwischen 0 und 20, vorzugsweise zwischen 1 und 10, insbesondere zwischen 1 und 6;
mit der Maßgabe, dass die Anzahl dieser Gruppen gemäß Formel (I) bzw. Formel (II) bzw. Formel (III) durch die maximal verfügbaren, d. h. substituierbaren H-Atome begrenzt ist.

Die Vernetzung dieser Einheiten wird durch thermisches Behandeln der Vorrichtung in diesem Stadium durchgeführt. Es ist nicht nötig und auch nicht wünschenswert, für die Vernetzung eine Photosäure zuzusetzen, da dadurch Verunreinigungen in das Device eingebracht werden. Ohne an eine spezielle Theorie gebunden sein zu wollen, vermuten wir, dass durch die aus der leitfähigen, dotierten Polymerschicht austretenden Protonen die Vernetzung der Pufferschicht ausgelöst wird. Bevorzugt findet diese Vernetzung bei einer Temperatur von 80 bis 200 °C und einer Dauer von 0.1 bis 120 Minuten, bevorzugt 1 bis 60 Minuten, besonders bevorzugt 1 bis 10 Minuten, in einer inerten Atmosphäre statt. Besonders bevorzugt findet diese Vernetzung bei einer Temperatur von 100 bis 180 °C und einer Dauer von 20 bis 40 Minuten in einer inerten Atmosphäre statt. Es kann auch vorteilhaft sein, der Pufferschicht zur Vernetzung weitere Hilfsstoffe zuzusetzen, die keine Photosäuren sind, die aber die Vernetzung fördern können. Hier kommen beispielsweise Salze, insbesondere organische Salze, wie beispielsweise Tetrabutylammoniumhexafluoroantimonat, die als Leitsalze zur besseren Vernetzung zugesetzt werden, Säuren, insbesondere organische Säuren, wie beispielsweise Essigsäure oder Zusatz von weiterer Polystyrolsulfonsäure zum leitfähigen Polymer, oder oxidierende Stoffe, wie beispielsweise Nitrylium- oder Nitrosylium-Salze (NO⁺, NO₂⁺), in Frage. Diese Hilfsstoffe können nach durchgeführter Vernetzung leicht ausgewaschen werden und verbleiben somit nicht als Verunreinigung im Film. Die Hilfsstoffe haben den Vorteil, dass dadurch die Vernetzung leichter vollständig durchgeführt werden kann und dass dadurch auch dickere Pufferschichten erzeugt werden können.

Für die Herstellung der Vorrichtungen wird in der Regel folgendes allgemeine Verfahren angewandt, das entsprechend ohne weiteres erfinderisches Zutun für den Einzelfall anzupassen ist:
- Ein Substrat (z. B. Glas oder auch ein Kunststoff) wird mit der Anode beschichtet (beispielsweise Indium-Zinn-Oxid, ITO, etc.). Anschließend wird die Anode (z. B. photolithografisch) der gewünschten Anwendung gemäß strukturiert und verschaltet. Es kann hier auch sein, dass das ganze Substrat und die entsprechende Verschaltung zunächst über einen recht aufwändigen Prozess erzeugt wird, um dadurch eine sogenannte Aktiv-Matrix-Steuerung zu ermöglichen. Das mit der Anode beschichtete vorgereinigte Substrat wird entweder mit Ozon oder mit Sauerstoffplasma behandelt oder kurze Zeit mit einer Excimer-Lampe bestrahlt.
- Anschließend wird ein leitfähiges Polymer, z. B. ein dotiertes Polythiophen-(PEDOT) oder Polyanilinderivat (PANI) in einer dünnen Schicht üblicherweise zwischen 10 und 500 nm, bevorzugt zwischen 20 und 300 nm Schichtdicke, auf das ITO-Substrat durch Spincoaten oder andere Beschichtungsverfahren aufgebracht .
- Auf diese Schicht wird die erfindungsgemäße kationisch vernetzbare Pufferschicht aufgebracht. Die entsprechende Verbindung wird dazu zunächst in einem Lösemittel oder Lösemittelgemisch gelöst und filtriert. Da organische Halbleiter und v. a. die Oberflächen der Schichten teilweise extrem durch Sauerstoff oder andere Luftbestandteile beeinflusst werden, empfiehlt es sich, diese Operation unter Schutzgas durchzuführen. Als Lösemittel für polymere Verbindungen eignen sich aromatische Flüssigkeiten wie beispielsweise Toluol, Xylole, Anisol, Chlorbenzol, aber auch andere, wie beispielsweise cyclische Ether (z. B. Dioxan, Methyldioxan, THF) oder auch Amide, wie beispielsweise NMP oder DMF, aber auch Lösemittelgemische, wie in der Anmeldeschrift WO 02/072714 beschrieben. Für niedermolekulare Verbindungen eignen sich auch weitere organische Lösemittel, die abhängig von der verwendeten Verbindungsklasse gewählt werden. Mit diesen Lösungen können die vorher beschriebenen Träger ganzflächig beschichtet bzw. lackiert werden, z. B. durch Spin-Coat-Verfahren, Schwall- und Wellenbeschichtung oder Rackel-Techniken. Die Vernetzung der Pufferschicht kann dann durch Erhitzen des Devices in diesem Stadium in einer inerten Atmosphäre erfolgen. Es ist hier nicht nötig und auch nicht wünschenswert, eine Photosäure zuzusetzen; die thermische Behandlung der Pufferschicht auf dem dotierten Polymer reicht aus, um die Vernetzungsreaktion durchzuführen. Optional kann anschließend mit einem Lösungsmittel, beispielsweise THF, gespült werden. Abschließend wird eventuell getrocknet.
- Darauf bringt man dann eine Lösung eines organischen Halbleiters auf. Die Wahl des Halbleiters hängt von der gewünschten Anwendung ab. Wird ein vernetzbarer organischer Halbleiter verwendet, kann dieser entsprechend der gewünschten Anwendung durch gezielte Vernetzung strukturiert werden. Dies kann bei kationisch vernetzbaren Halbleitern beispielsweise durch Zusatz einer Photosäure, Bestrahlung durch eine Schattenmaske und anschließende thermische Behandlung erfolgen. Da die darunter liegende Pufferschicht nicht sauer ist, sollte an dieser Stelle nicht auf die Verwendung einer Photosäure verzichtet werden. Der nicht-vernetzte Anteil des Halbleiters kann anschließend mit einem organischen Lösemittel, in dem der Halbleiter löslich ist, abgewaschen werden. Dieser Prozess kann für unterschiedliche Materialien wiederholt werden, um auf diese Weise strukturiert mehrere Materialien nebeneinander aufzubringen. So können beispielsweise elektrolumineszierende Polymere unterschiedlicher Emissionsfarbe strukturiert nebeneinander für ein Vollfarbdisplay oder organische Feldeffekttransistoren verschiedener Funktion nebeneinander für organische Schaltungen aufgebracht werden. Es können auch mehrere vernetzbare Schichten übereinander aufgebracht werden.
- Auf diese Polymerschichten können optional weitere funktionelle Schichten, wie beispielsweise Ladungsinjektions- oder -transportschichten , weitere Emissionsschichten und/oder Lochblockierschichten aufgebracht werden, z. B. aus Lösung durch Methoden, wie diese für die Pufferschicht beschrieben wurden, aber auch durch Aufdampfen.
- Anschließend wird eine Kathode aufgebracht. Dies erfolgt nach dem Stand der Technik durch einen Vakuumprozess und kann beispielsweise durch thermisches Bedampfen oder durch Plasmaspritzen (Sputtern) geschehen. Die Kathode kann dabei vollflächig oder auch durch eine Maske strukturiert aufgebracht werden. Dann erfolgt die Kontaktierung der Elektroden.
- Da viele der Anwendungen empfindlich auf Wasser, Sauerstoff oder sonstige Bestandteile der Atmosphäre reagieren, ist eine effektive Einkapselung des Devices unerlässlich.
- Der oben beschriebene Aufbau wird für die einzelnen Anwendungen entsprechend angepasst und optimiert und kann allgemein für verschiedene Anwendungen, wie organische und polymere Leuchtdioden, organische Solarzellen, organische Feldeffektransitoren, organische Schaltelemente, organische optische Verstärker oder organische Laserdioden verwendet werden.

Überraschend bietet diese vernetzbare Pufferschicht, die zwischen das leitfähige, dotierte Polymer und den organischen Halbleiter eingebracht wird, folgende Vorteile:
1) Durch Einbringen der erfindungsgemäßen vernetzbaren Pufferschicht verbessern sich die optoelektronischen Eigenschaften der elektronischen Vorrichtung gegenüber einer Vorrichtung, die keine derartige Pufferschicht enthält. So beobachtet man eine höhere Effizienz und eine höhere Lebensdauer bei verringerter Betriebsspannung. Dabei fällt auf, dass dieser Effekt besonders ausgeprägt ist, wenn die Vernetzung der Pufferschicht thermisch initiiert wird. Wird der Pufferschicht zur Vernetzung eine Photosäure zugesetzt, wie in der Literatur beschrieben, bleibt die Lebensdauer praktisch unverändert.
2) Da die Pufferschicht vermutlich kationische Spezies abfängt, die aus dem leitfähigen, dotierten Polymer austreten, werden diese an der Diffusion in den organischen Halbleiter gehindert. Handelt es sich bei dem organischen Halbleiter nun um eine kationisch vernetzbare Verbindung, wird so eine ungewollte Vernetzung des Halbleiters wird vermieden. Dadurch wird die kontrollierte Strukturierung des Halbleiters erst ermöglicht, die bislang so nicht möglich war.

Die vorliegende Erfindung wird durch die folgenden Beispiele näher erläutert, ohne sie darauf einschränken zu wollen. In diesen Beispielen wird nur auf organische und polymere Leuchtdioden eingegangen. Der Fachmann kann jedoch aus den aufgeführten Beispielen ohne erfinderisches Zutun weitere elektronische Vorrichtungen darstellen, wie beispielsweise O-SCs, O-FETs, O-ICs, optische Verstärker und O-Laser, um nur einige weitere Anwendungen zu nennen.

### Beispiele:

### Beispiel 1: Synthese eines kationisch vernetzbaren Polymers P1 für die Verwendung als Pufferschicht

### a) Synthese literaturbekannter Vorstufen

3-Ethyl-3-(iodmethyl)oxetan (WO 96/21657), 11-(4-Bromphenoxy)-1-undecanol (M. Trollsaas et al., Macromol. Chem. Phys. 1996, 197, 767-779) und N,N'-Diphenylbenzidin (K. Wiechert et al., Zeitschrift Chem. 1975, 15, 49-50) wurden gemäß der Literatur synthetisiert.

### b) Synthese von N,N'-Bis-(4-bromphenyl)-N,N'-bis-(4-tert-butylphenyl)-biphenyl-4,4'-diamin (Monomer M1)

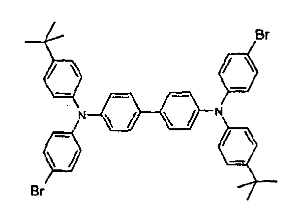

Die Synthese von Monomer **M1** ist in WO 02/077060 beschrieben.

### c) Synthese von N,N'-Bis-(4-boronsäurepinakolester)phenyl-N,N'-bis-(4-tert-butylphenyl)-biphenyl-4,4'-diamin (Monomer M2)

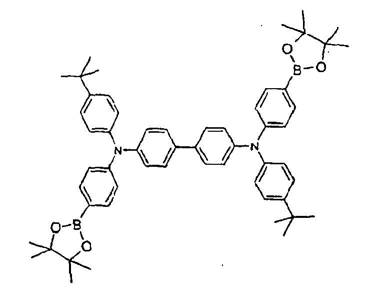

Die Synthese von Monomer **M2** ist in der nicht offen gelegten Anmeldung DE 10337077.3 beschrieben.

### d) Synthese von 3-(11-(4-Bromphenoxy)-undecan-1-oxy)methylen-3-ethyl-oxetan

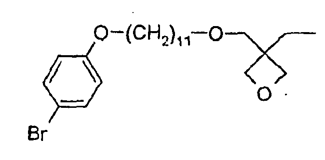

1.6 g (30 mmol) NaH wurden in 70 mL trockenem DMF suspendiert und unter Schutzgas gerührt. Dazu wurde bei 40 °C eine Lösung aus 6.8 g (20 mmol) 11-(4-Bromphenoxy)-1-undecanol in 25 ml DMF gegeben. Nach 1 h wurden 2.96 g (22 mmol) 3-Ethyl-3-(iodmethyl)oxetan und 0.166g (1.0 mmol) KI zugegeben und 24 h bei 40 °C gerührt. Nach Abkühlen auf Raumtemperatur wurde die Reaktionsmischung mit 200 mL Wasser und 200 mL CH₂Cl₂ versetzt, die organische Phase wurde abgetrennt, über Mg₂SO₄ getrocknet und das Lösungsmittel im Vakuum entfernt. Das Produkt wurde chromatographisch gereinigt (Silica, Laufmittel Hexan). Die Ausbeute betrug 3.2 g (89 % d. Th.), die Reinheit 98 % (nach HPLC). ¹H-NMR (CDCl₃, 500 MHz): 1.45 (t, J = 7.3 Hz, 3H), 1.45 (m, 14H), 1.55 (m, 2H), 1.75 (m, 4H), 3.42 (t, J = 6.3 Hz, 2H), 3.46 (s, 2H), 3.85 (t, J = 6.3 Hz, 2H), 4.39 (d, J = 5.9 Hz, 2H), 4.44 (d, J = 5.9 Hz, 2H), 6.75 (d, J = 9 Hz, 2H), 7.35 (d, J = 9 Hz, 2H).

### e) Synthese von Oxetan-substituiertem N,N,N',N'-Tetraphenylbenzidin

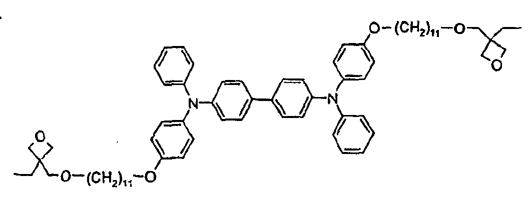

Eine entgaste Lösung von 5.1 g (9.7 mmol) N,N'-Diphenylbenzidin und 14 g (21.4 mmol) 3-(11-(4-Bromphenoxy)-undecan-1-oxy)methylen-3-ethyl-oxetan in 250 mL Toluol wurde 1 h mit N₂ gesättigt. Dann wurde die Lösung zunächst mit 0.12 g (0.39 mmol) P(^{t}Bu)₃, dann mit 69 mg (0.19 mmol) Pd(OAc)₂ versetzt. Anschließend wurden 3.8 g (50.4 mmol) festes NaO^{t}Bu zugegeben. Die Reaktionsmischung wurde 5 h unter Rückfluss erhitzt. Nach Abkühlen auf Raumtemperatur wurden 0.85 g NaCN und 10 mL Wasser zugesetzt. Die organische Phase wurde mit 4 x 50 mL H₂O gewaschen, über MgSO₄ getrocknet und die Lösungsmittel in Vakuum entfernt. Das reine Produkt erhielt man durch Umkristallisation aus Dioxan in einer Reinheit von 99.2 % (gemäß HPLC). Die Ausbeute betrug 12 g (75 % d. Th.).
¹H-NMR (CDCl₃, 500 MHz): 0.81 (t, J = 7.3 Hz, 6H), 1.17 (t, J = 7.0 Hz, 12H), 1.23-1.35 (m, 28H), 3.94 (t, J = 6.3 Hz, 4H), 4.03 (t, J = 6.3 Hz, 8H), 4.21 (d, J = 5.9 Hz, 4H), 4.29 (d, J = 5.9 Hz, 4H), 6.91-7.01 (m, 14H), 7.04 (d, J = 9 Hz, 4H), 7.27 (d, J = 8 Hz, 4H), 7.49 (d, J = 8.7 Hz, 4H).

### f) Synthese von Oxetan-substituiertem, bromierten N,N,N',N'-Tetraphenylbenzidin (Monomer M3)

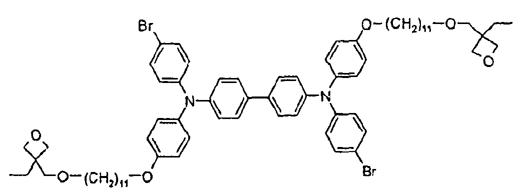

45.72 g (43.7 mmol) Oxetan-substituiertes N,N,N',N'-Tetraphenylbenzidin wurden in 500 mL THF vorgelegt. Dazu wurde bei 0 °C unter Lichtausschluss eine Lösung aus 15.15 g (84.4 mmol) NBS in 300 mL THF getropft. Man ließ auf RT kommen und rührte 4 h weiter. Es wurden 500 mL Wasser zugesetzt, und die Mischung wurde mit CH₂Cl₂ extrahiert. Die organische Phase wurde über MgSO₄ getrocknet und die Lösungsmittel in Vakuum entfernt. Das Produkt wurde mit Hexan heiß ausgerührt und abgesaugt. Nach wiederholter chromatographischer Aufreinigung (Silica, Hexan/Ethylacetat 4:1) erhielt man das Produkt in einer Ausbeute von 44 g (85 % d. Th.) als blassbraunes Öl, welches eine Reinheit von 99.2 % (gemäß HPLC) aufwies. ¹H-NMR (DMSO-d₆, 500 MHz): 0.81 (t, J = 7.3 Hz, 6H), 1.17 (t, J = 7.0 Hz, 12H), 1.23-1.35 (m, 28H), 3.94 (t, J = 6.3 Hz, 4H), 4.03 (t, J = 6.3 Hz, 8H), 4.21 (d, J = 5.9 Hz, 4H), 4.29 (d, J = 5.9 Hz, 4H), 6.91-7.02 (m, 12H), 7.04 (d, J = 9 Hz, 4H), 7.29 (d, J = 8 Hz, 4H), 7.51 (d, J = 8.7 Hz, 4H).

### g) Polymersynthese: Synthese von Polymer P1

1.7056 g (2 mmol) Monomer **M2,** 0.9104 g (1.2 mmol) Monomer **M1**, 0.9723 g (0.8 mmol) Monomer **M3** und 2.03 g (4.4 mmol) Kaliumphosphat-Hydrat wurden in 12.5 mL Toluol, 12.5 mL Dioxan und 12 mL Wasser (alle Lösungsmittel sauerstofffrei) gelöst und bei 40 °C 30 Minuten mit einem Argonstrom entgast. Dann wurden 0.90 mg Pd(OAc)₂ und 6.30 mg P(o-tol)₃ als Katalysator zugegeben, und die Reaktionsmischung wurde 3 h unter Rückfluss erhitzt. Es wurden 20 mL Toluol und als Endcapper 12 mg (0.04 mmol) 3,4-Bispentoxybenzolboronsäure zugegeben, 1 h unter Rückfluss erhitzt, dann wurden 20 mg (0.06 mmol) 3,4-Bispentoxybenzolbromid zugegeben und 1 h unter Rückfluss erhitzt. Die Reaktionslösung wurde auf 65°C abgekühlt und 4 h mit 10 mL 5 %iger wässriger Natrium-N,N,Diethyldithiocarbamat-Lösung ausgerührt. Die organische Phase wurde mit 3 x 80 mL Wasser gewaschen und durch Zugabe in das doppelte Volumen Methanol ausgefällt. Das Rohpolymer wurde in Chlorbenzol gelöst, über Celit filtriert und durch Zugabe des doppelten Volumens Methanol gefällt. Man erhielt 2.24 g (78 % d. Th.) des Polymers **P1**.

### Beispiel 2: Synthese eines kationisch vernetzbaren Polymers P2 für die Verwendung als Pufferschicht

### a) Synthese von Bis-(4-bromphenyl)-(4-^{sec}butylphenyl)-amin (Monomer M4)

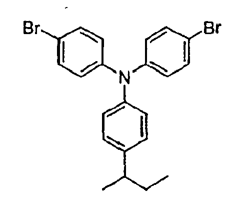

Die Synthese von Monomer **M4** wurde in Analogie zur Synthese in DE 19981010 durchgeführt.

### b) Synthese von Bis-((4-boronsäurepinakolester)phenyl)- (4-^{sec}butylphenyl)-amin (Monomer M5)

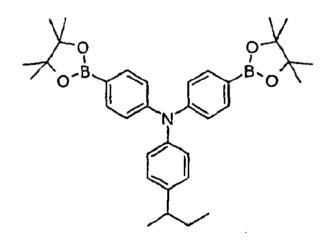

Die Synthese von Monomer **M5** ist in der nicht offen gelegten Anmeldung DE 10337077.3 beschrieben.

### c) Synthese von 2,7-Dibrom-(2,5-dimethylphenyl)-9-(3,4-di(3-ethyl(oxetan-3-ethyloxy)-hexyloxyphenyl))-fluoren (Monomer M6)

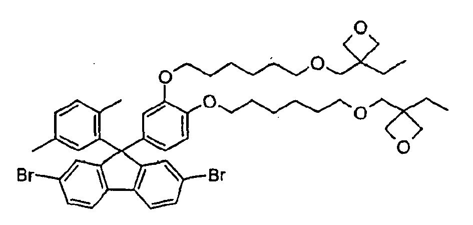

Die Synthese von Monomer **M6** ist in C. D. Müller et al., Nature 2003, 421, 829 beschrieben.

### d) Polymersynthese: Synthese von Polymer P2

1.4695 g (3.2 mmol) Monomer **M4,** 2.2134 g (4 mmol) Monomer **M5,** 0.7463 g (0.8 mmol) Monomer **M6** und 4.05 g (8.8 mmol) Kaliumphosphat-Hydrat wurden in 25 mL Toluol, 25 mL Dioxan und 25 mL Wasser (alle Lösungsmittel sauerstofffrei) gelöst und bei 40 °C 30 Minuten mit einem Argonstrom entgast. Dann wurden 1.80 mg Pd(OAc)₂ und 14.61 mg P(o-tol)₃ zugegeben, und die Reaktionsmischung wurde 10 h unter Rückfluss erhitzt. Dabei wurden nach 4 h, nach 5.5 h und nach 8.5 h jeweils die Ausgangsmengen an Pd(OAc)₂ und P(o-tol)₃ zugegeben. Nach 8 h Reaktionszeit wurden 2 mL Toluol zugegeben. Als Endcapper wurden 24 mg (0.08 mmol) 3,4-Bispentoxybenzolboronsäure zugegeben, 2 h unter Rückfluss erhitzt, dann wurden 40 mg (0.12 mmol) 3,4-Bispentoxybenzolbromid zugegeben und 1 h unter Rückfluss erhitzt. Die Reaktionslösung wurde auf 65 °C abgekühlt und 4 h mit 20 mL 5 %iger wässriger Lösung von Natrium-N,N-Diethyldithiocarbamat ausgerührt. Die Phasen wurden getrennt und der Vorgang wurde noch einmal mit 40 mL der Dithiocarbamat-Lösung wiederholt. Die Phasen wurden getrennt, die organische Phase mit 3 x 150 mL Wasser gewaschen und durch Zugabe in das doppelte Volumen Methanol ausgefällt. Das Rohpolymer wurde in Chlorbenzol gelöst, über Celit filtriert und durch Zugabe des doppelten Volumens Methanol gefällt. Man erhielt 1.84 g (64 % d. Th.) des Polymers **P2,** das in Chlorbenzol löslich, jedoch in Toluol, THF oder Chloroform unlöslich ist.

### Beispiel 3: Synthese eins kationisch vernetzbaren Moleküls V1 für die Verwendung als Pufferschicht

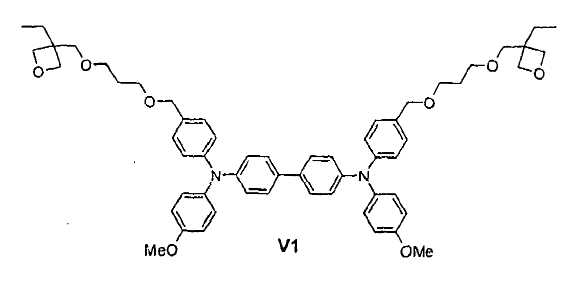

Die Synthese des kationisch vernetzbaren Moleküls **V1** ist in M. S. Bayer et al., Macromol. Rapid Commun. 1999, 20, 224-228 beschrieben.

Die Deviceergebnisse, die bei Verwendung des Polymers **P1** und **P2** bzw. des Moleküls **V1** als Pufferschicht erhalten wurden, sind in Beispiel 6-8 zusammengefasst.

### Beispiel 4: Herstellung von LEDs mit einer zusätzlichen Pufferschicht

Die Herstellung der LEDs erfolgte nach einem allgemeinen Verfahren, welches im Einzelfall auf die jeweiligen Gegebenheiten (z. B. Lösungsviskosität und optimale Schichtdicke der funktionellen Schichten im Device) angepasst wurde. Die nachfolgend beschriebenen LEDs waren jeweils Dreischichtsysteme (drei organische Schichten), d. h. Substrat//ITO//PEDOT//Pufferschicht//Polymer//Kathode. PEDOT ist ein Polythiophen-Derivat (Baytron P4083 von H. C. Stark, Goslar). Als Kathode wurde in allen Fällen Ba von der Firma Aldrich und Ag von der Firma Aldrich verwendet. Wie PLEDs allgemein dargestellt werden können, ist in WO 04/037887 und der darin zitierten Literatur ausführlich beschrieben.

Davon abweichend wurde hier auf die PEDOT-Schicht ein kationisch vernetzbarer Halbleiter als Pufferschicht aufgebracht. Als Materialien für die Pufferschicht wurden hier die vernetzbaren Polymere **P1** und **P2** bzw. die vernetzbare niedermolekulare Verbindung **V1** verwendet. Von dem vernetzbaren Material wurde eine Lösung (mit einer Konzentration von 4-25 mg/ml in beispielsweise Toluol, Chlorbenzol, Xylol, etc.) angesetzt und durch Rühren bei Raumtemperatur gelöst. Je nach Material kann es auch vorteilhaft sein, für einige Zeit bei 50 - 70 °C zu rühren. Nach vollständigem Lösen der Verbindung wurde sie durch einen 5 µm Filter filtriert. Dann wurde die Pufferschicht bei variablen Geschwindigkeiten (400 - 6000 rpm) mit einem Spincoater in einer inerten Atmosphäre aufgeschleudert. Die Schichtdicken konnten dadurch im Bereich von ca. 20 bis 300 nm variiert werden. Anschließend erfolgte die Vernetzung durch Erhitzen des Devices auf 180 °C für 30 Minuten auf einer Heizplatte in einer inerten Atmosphäre. Auf die Pufferschicht werden nun der organische Halbleiter und die Kathode aufgebracht, wie in WO 04/037887 und der darin zitierten Literatur beschrieben.

### Beispiel 5: Herstellung von strukturierten LEDs mit einer zusätzlichen Pufferschicht

Die Herstellung der strukturierten LEDs erfolgte analog zu Beispiel 4 bis einschließlich zum Schritt der Vernetzung der Pufferschicht. Abweichend dazu wurden als organische Halbleiter kationisch vernetzbare Halbleiter verwendet. Dies waren rot, grün und blau emittierende konjugierte Polymere auf Basis von Poly-Spirobifluoren, die mit Oxetangruppen funktionalisiert wurden. Diese Materialien und deren Synthese sind bereits in der Literatur beschrieben (Nature 2003, 421, 829). Von den kationisch vernetzbaren Halbleitern wurde eine Lösung (in der Regel mit einer Konzentration von 4-25 mg/ml in beispielsweise Toluol, Chlorbenzol, Xylol:Cyclohexanon (4:1)) angesetzt und durch Rühren bei Raumtemperatur gelöst. Je nach Verbindung kann es auch vorteilhaft sein, für einige Zeit bei 50 - 70 °C zu rühren. Dabei wurden den Lösungen des kationisch vernetzbaren Halbleiters noch ca. 0.5 Gew.% (bezogen auf das Polymer) der Photosäure {4-[(2-hydroxytetradecyl)-oxyl]-phenyl}-phenyliodonium hexafluoroantimonat zugesetzt. Auf die vernetzte Pufferschicht wurde nun durch Spincoating unter vergleichbaren Bedingungen wie für die Pufferschicht die Lösung des ersten kationisch vernetzbaren Halbleiters und der Photosäure aufgebracht. Nach Trocknen des Films wurde durch Bestrahlung mit einer UV-Lampe (10 W, 302 nm, 5 Min.) durch eine Maske strukturiert vernetzt. Der Film wurde dann in einer inerten Atmosphäre 3 Minuten bei 130°C getempert, anschließend mit einer 10⁻⁴-molaren LiAlH₄-Lösung in THF behandelt und mit THF nachgespült. Dadurch wurden die nicht-vernetzten Stellen im Film abgewaschen. Dieser Vorgang wird mit den weiteren Lösungen der vernetzbaren organischen Halbleiter wiederholt, und auf diese Weise wurden die drei Grundfarben strukturiert nebeneinander aufgebracht. Das Aufdampfen der Elektroden und die Kontaktierung erfolgten dann, wie oben beschrieben.

### Beispiel 6: Lebensdauermessung einer LED mit einer zusätzlichen Pufferschicht P1

Die LED wurde hergestellt, wie in Beispiel 4 beschrieben. Dabei wurden 20 nm PEDOT verwendet. Als Pufferschicht wurde eine 20 nm dicke Schicht von Polymer **P1** aufgebracht, die wie in Beispiel 4 beschrieben thermisch vernetzt wurde. Als halbleitendes Polymer wurde ein blau emittierendes Polymer verwendet (Zusammensetzung: 50 mol% Monomer **M7,** 30 mol% Monomer **M8**, 10 mol% Monomer **M1**, 10 mol% Monomer **M9**). Die Monomere sind unten abgebildet, ihre Synthese ist in WO 03/020790 beschrieben. Das Polymer zeigte in der Elektrolumineszenz eine Lebensdauer (= Helligkeitsabfall auf die Hälfte der Anfangshelligkeit) von ca. 1600 h bei Raumtemperatur und einer Anfangshelligkeit von 300 cd/m². In einer Vergleichs-LED ohne die Pufferschicht zeigte das Polymer unter ansonsten gleichen Bedingungen eine Lebensdauer von ca. 500 h. Es wurde außerdem eine LED hergestellt, deren Pufferschicht unter Zusatz von 0.5 Gew.% {4-[(2-hydroxytetradecyl)-oxyl]-phenyl}-phenyliodonium hexafluoroantimonat photochemisch durch UV-Bestrahlung (3 s, 302 nm) und anschließendes Erhitzen auf 90°C für 30 Sekunden vernetzt wurde. Die Pufferschicht wurde anschließend mit THF gespült und 5 Minuten auf 180°C erhitzt. Diese LED hatte unter ansonsten gleichen Bedingungen eine Lebensdauer von ca. 630 h.

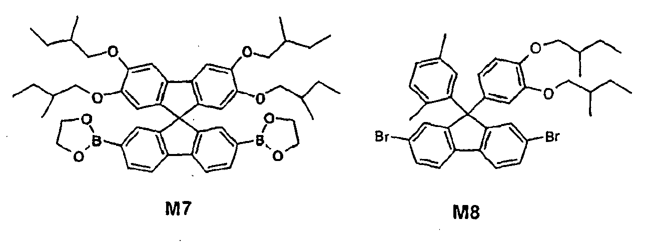

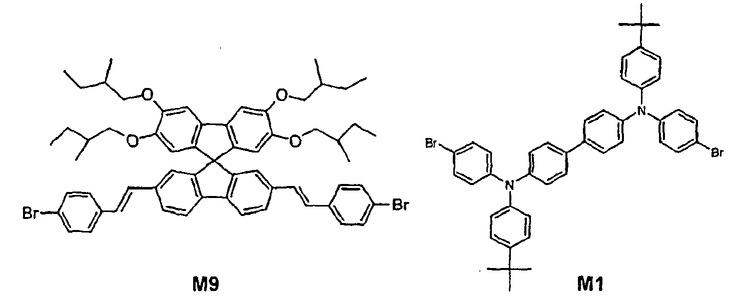

### Beispiel 7: Lebensdauermessung einer LED mit einer zusätzlichen Pufferschicht P2

Die Messung wurde wiederholt mit Polymer **P2** als Pufferschicht, wie in Beispiel 6 beschrieben unter ansonsten identischen Bedingungen. Das Polymer zeigte eine Lebensdauer von ca. 1500 h ohne Zusatz von Photosäure zur Pufferschicht und von ca. 600 h mit Zusatz von Photosäure.

### Beispiel 8: Lebensdauermessung einer LED mit einer zusätzlichen Pufferschicht V1

Die Messung wurde wiederholt mit Verbindung **V1** als Pufferschicht, wie in Beispiel 6 beschrieben unter ansonsten identischen Bedingungen. Das Polymer zeigte eine Lebensdauer von ca. 1350 h ohne Zusatz von Photosäure zur Pufferschicht und von ca. 550 h mit Zusatz von Photosäure.

## Patentansprüche

1. Elektronische Vorrichtung, enthaltend mindestens eine Schicht eines leitfähigen, durch Säuren oder durch Oxidationsmittel dotierten Polymers und mindestens eine Schicht eines organischen Halbleiters, **dadurch gekennzeichnet, dass** zwischen diesen Schichten mindestens eine leitende oder halbleitende organische Pufferschicht eingebracht ist, welche durch Temperaturerhöhung auf 50 bis 250°C kationisch vernetzbar ist und der keine Photosäure zugesetzt ist, und **dass** als Materialien für die Pufferschicht Materialien verwendet werden, die mindestens eine heterocyclische Gruppe aufweisen, die kationisch ringöffnend polymerisierbar ist und es sich bei der kationisch polymerisierbaren heterocyclischen Gruppe um eine Gruppe der Formel (I), (II) oder (III) handelt, 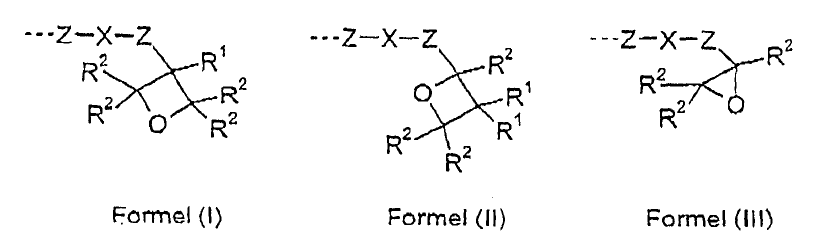 wobei gilt
R¹ ist bei jedem Auftreten gleich oder verschieden Wasserstoff, eine geradkettige, verzweigte oder cyclische Alkyl-, Alkoxy- oder Thioalkoxy-Gruppe mit 1 bis 20 C-Atomen, ein aroma- tisches oder heteroaromatisches Ringsystem mit 4 bis 24 aromatischen Ringatomen oder eine Alkenylgruppe mit 2 bis 10 C-Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R¹ miteinander bzw. mit R², R³ und/oder R⁴ ein mono- oder polycyclisches, aliphatisches oder aromatisches Ringsystem bilden;
R² ist bei jedem Auftreten gleich oder verschieden Wasserstoff, eine geradkettige, verzweigte oder cyclische Alkylgruppe mit 1 bis 20 C-Atomen, ein aromatisches oder heteroaromati- sches Ringsystem mit 4 bis 24 aromatischen Ringatomen oder eine Alkenylgruppe mit 2 bis 10 C-Atomen, bei denen ein oder mehrere Wasserstoffatome durch Halogen, wie Cl und F, oder CN ersetzt sein können und ein oder mehrere nicht benachbarte C-Atome durch -O-, -S-, -CO-, -COO- oder -O-CO- ersetzt sein können; dabei können auch mehrere Reste R² miteinander bzw. mit R¹, R³ und/oder R⁴ ein mono- oder polycyclisches, aliphatisches oder aromatisches Ringsystem bilden;
X ist bei jedem Auftreten gleich oder verschieden -O-, -S-, -CO-, -COO-, -O-CO- oder eine bivalente Gruppe -(CR³R⁴)ₙ-;
Z ist bei jedem Auftreten gleich oder verschieden eine bivalente Gruppe -(CR³R⁴)ₙ-;
R³, R⁴ ist bei jedem Auftreten gleich oder verschieden Wasserstoff, eine geradkettige, verzweigte oder cyclische Alkyl-, Alkoxy- oder Thioalkoxy-Gruppe mit 1 bis 20 C-Atomen, ein aroma- tisches oder heteroaromatisches Ringsystem mit 4 bis 24 aromatischen Ringatomen oder eine Alkenyl-Gruppe mit 2 bis 10 Atomen, bei denen ein oder mehrere Wasserstoffatome auch durch Halogen, wie Cl oder F, oder CN ersetzt sein können; dabei können auch zwei oder mehr Reste R³ bzw. R⁴ miteinander bzw. auch mit R¹ oder R² ein Ringsystem bilden;
n ist bei jedem Auftreten gleich oder verschieden eine ganze Zahl zwischen 0 und 20:
mit der Maßgabe, dass die Anzahl dieser Gruppen gemäß Formel (I) bzw. Formel (II) bzw. Formel (III) durch die maximal verfügbaren, d. h. substituierbaren H-Atome begrenzt ist.

2. Elektronische Vorrichtung gemäß Anspruch 1, **dadurch gekennzeichnet, dass** es sich um organische oder polymere Leuchtdioden (OLED, PLED), organische Solarzellen (O-SC), organische Feld-Effekt-Transistoren (O-FET), organische Schaltelemente (O-IC), organische Feld-Quench Devices (O-FQD), organische optische Verstärker oder organische Laserdioden (O-Laser) handelt.

3. Elektronische Vorrichtung gemäß einem oder mehreren der Ansprüche 1 bis 2, **dadurch gekennzeichnet, dass** sie folgende Elemente enthält: Substrat, Elektrode (Anode oder Kathode), Zwischenschicht aus einem leitfähigen, dotierten Polymer, leitende oder halbleitende organische, kationisch vernetzbare Pufferschicht, organische Halbleiterschicht und Gegenelektrode (Kathode oder Anode).

4. Elektronische Vorrichtung gemäß einem oder mehreren der Ansprüche 1 bis 3, **dadurch gekennzeichnet, dass** zwischen eine metallische Kathode und den organischen Halbleiter eine Zwischenschicht eines Materials mit einer hohen Dielektrizitätskonstanten eingebracht ist.

5. Elektronische Vorrichtung gemäß einem oder mehreren der Ansprüche 1 bis 4, **dadurch gekennzeichnet, dass** als Anode Materialien mit einem Potenzial größer 4.5 eV vs. Vakuum verwendet werden.

6. Elektronische Vorrichtung gemäß einem oder mehreren der Ansprüche 1 bis 5, **dadurch gekennzeichnet, dass** das leitfähige dotierte Polymer eine Leitfähigkeit von > 10⁻⁸ S/cm und ein Potenzial von 4 - 6 eV vs. Vakuum aufweist.

7. Elektronische Vorrichtung gemäß Anspruch 6, **dadurch gekennzeichnet, dass** als leitfähiges Polymer Derivate von Polythiophen oder Polyanilin verwendet werden und die Dotierung durch polymergebundene Brönsted-Säuren erfolgt.

8. Elektronische Vorrichtung gemäß einem oder mehreren der Ansprüche 1 bis 7, **dadurch gekennzeichnet, dass** als organische Halbleiter niedermolekulare, oligomere, dendritische oder polymere halbleitende Materialien verwendet werden.

9. Elektronische Vorrichtung gemäß Anspruch 8, **dadurch gekennzeichnet, dass** der organische Halbleiter ein konjugiertes Polymer ist.

10. Elektronische Vorrichtung gemäß Anspruch 8 und/oder 9, **dadurch gekennzeichnet, dass** der organische Halbleiter eine kationisch vernetzbare Verbindung ist.

11. Elektronische Vorrichtung gemäß einem oder mehreren der Ansprüche 1 bis 10, **dadurch gekennzeichnet, dass** die organische Pufferschicht niedermolekular, oligomer, dendritisch oder polymer ist.

12. Elektronische Vorrichtung gemäß einem oder mehreren der Ansprüche 1 bis 11, **dadurch gekennzeichnet, dass** die Schichtdicke der Pufferschicht im Bereich von 5 - 300 nm liegt.

13. Elektronische Vorrichtung gemäß einem oder mehreren der Ansprüche 1 bis 12, **dadurch gekennzeichnet, dass** das Potenzial der Pufferschicht zwischen dem Potenzial des leitfähigen, dotierten Polymers und dem des organischen Halbleiters liegt.

14. Elektronische Vorrichtung gemäß einem oder mehreren der Ansprüche 1 bis 13, **dadurch gekennzeichnet, dass** für die Pufferschicht kationisch vernetzbare, lochleitende Materialien verwendet werden.

15. Elektronische Vorrichtung gemäß Anspruch 14, **dadurch gekennzeichnet, dass** für die Pufferschicht kationisch vernetzbare Materialien auf Triarylamin-Basis, auf Thiophen-Basis oder auf Triarylphosphin-Basis verwendet werden.

## Claims

1. Electronic device comprising at least one layer of a conductive polymer doped by acids or by oxidants and at least one layer of an organic semiconductor, **characterised in that** at least one conducting or semiconducting organic buffer layer which is cationically crosslinkable by increasing the temperature to 50 to 250°C and to which no photoacid has been added is introduced between these layers and **in that** the materials used for the buffer layer are materials which contain at least one heterocyclic group which is capable of cationic ring-opening polymerisation and the cationically polymerisable heterocyclic group is a group of the formula (I), (II) or (III): 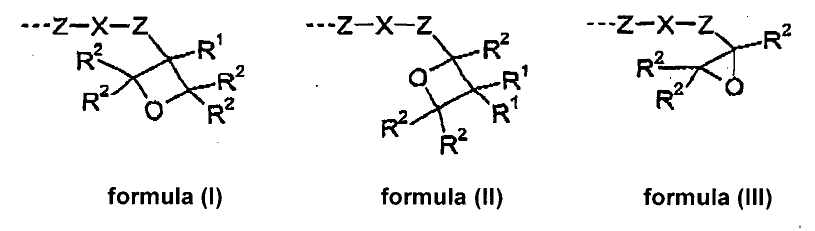 where
R¹ is on each occurrence, identically or differently, hydrogen, a straight-chain, branched or cyclic alkyl, alkoxy or thioalkoxy group having 1 to 20 C atoms, an aromatic or heteroaromatic ring system having 4 to 24 aromatic ring atoms or an alkenyl group having 2 to 10 C atoms, in which one or more hydrogen atoms may be replaced by halogen, such as Cl or F, or CN and one or more non-adjacent C atoms may be replaced by -O-, -S-, -CO-, -COO- or -O-CO-; a plurality of radicals R¹ here may also form a mono- or polycyclic, aliphatic or aromatic ring system with one another or with R², R³ and/or R⁴;
R² is on each occurrence, identically or differently, hydrogen, a straight-chain, branched or cyclic alkyl group having 1 to 20 C atoms, an aromatic or heteroaromatic ring system having 4 to 24 aromatic ring atoms or an alkenyl group having 2 to 10 C atoms, in which one or more hydrogen atoms may be replaced by halogen, such as Cl or F, or CN and one or more non-adjacent C atoms may be replaced by -O-, -S-, -CO-, -COO- or -O-CO-; a plurality of radicals R² here may also form a mono- or polycyclic, aliphatic or aromatic ring system with one another or with R¹, R³ and/or R⁴;
X is on each occurrence, identically or differently, -O-, -S-, -CO-, -COO-, -O-CO- or a divalent -(CR³R⁴)ₙ- group;
Z is on each occurrence, identically or differently, a divalent -(CR³R⁴)ₙ- group;
R³, R⁴ are on each occurrence, identically or differently, hydrogen, a straight-chain, branched or cyclic alkyl, alkoxy or thioalkoxy group having 1 to 20 C atoms, an aromatic or heteroaromatic ring system having 4 to 24 aromatic ring atoms or an alkenyl group having 2 to 10 C atoms, in which one or more hydrogen atoms may also be replaced by halogen, such as Cl or F, or CN; two or more radicals R³ or R⁴ here may also form a ring system with one another or alternatively with R¹ or R²;
n is on each occurrence, identically or differently, an integer between 0 and 20;
with the proviso that the number of these groups of the formula (I) or formula (II) or formula (III) is limited by the maximum number of available, i.e. substitutable, H atoms.

2. Electronic device according to Claim 1, **characterised in that** it is an organic or polymeric light-emitting diode (OLED, PLED), organic solar cell (O-SC), organic field-effect transistor (O-FET), organic integrated circuit (O-IC), organic field-quench device (O-FQD), organic optical amplifier or organic laser diode (O-laser).

3. Electronic device according to one or more of Claims 1 to 2, **characterised in that** it comprises the following elements: substrate, electrode (anode or cathode), interlayer comprising a conductive, doped polymer, conducting or semiconducting, organic, cationically crosslinkable buffer layer, organic semiconductor layer and counterelectrode (cathode or anode).

4. Electronic device according to one or more of Claims 1 to 3, **characterised in that** an interlayer of a material having a high dielectric constant is introduced between a metallic cathode and the organic semiconductor.

5. Electronic device according to one or more of Claims 1 to 4, **characterised in that** the anode used comprises materials having a potential of greater than 4.5 eV vs. vacuum.

6. Electronic device according to one or more of Claims 1 to 5, **characterised in that** the conductive, doped polymer has a conductivity of > 10⁻⁸ S/cm and a potential of 4 - 6 eV vs. vacuum.

7. Electronic device according to Claim 6, **characterised in that** the conductive polymer used comprises derivatives of polythiophene or polyaniline and the doping is carried out by polymer-bound Brönsted acids.

8. Electronic device according to one or more of Claims 1 to 7, **characterised in that** the organic semiconductor used comprises low-molecular-weight, oligomeric, dendritic or polymeric semiconducting materials.

9. Electronic device according to Claim 8, **characterised in that** the organic semiconductor is a conjugated polymer.

10. Electronic device according to Claim 8 and/or 9, **characterised in that** the organic semiconductor is a cationically crosslinkable compound.

11. Electronic device according to one or more of Claims 1 to 10, **characterised in that** the organic buffer layer is low-molecular-weight, oligomeric, dendritic or polymeric.

12. Electronic device according to one or more of Claims 1 to 11, **characterised in that** the layer thickness of the buffer layer is in the range 5 - 300 nm.

13. Electronic device according to one or more of Claims 1 to 12, **characterised in that** the potential of the buffer layer is between the potential of the conductive, doped polymer and that of the organic semiconductor.

14. Electronic device according to one or more of Claims 1 to 13, **characterised in that** cationically crosslinkable, hole-conducting materials are used for the buffer layer.

15. Electronic device according to Claim 14, **characterised in that** cationically crosslinkable materials based on triarylamine, based on thiophene or based on triarylphosphine are used for the buffer layer.

## Revendications

1. Dispositif électronique comprenant au moins une couche en un polymère conducteur dopé par des acides ou par des oxydants et au moins une couche en un semiconducteur organique, **caractérisé en ce qu'**au moins une couche tampon organique de conduction ou de semiconduction qui est cationiquement réticulable en augmentant la température jusqu'à 50 à 250°C et à laquelle aucun photoacide n'a été ajouté est introduite entre ces couches et **en ce que** les matériaux utilisés pour la couche tampon sont des matériaux qui contiennent au moins un groupe hétérocyclique qui est susceptible d'une polymérisation à ouverture de cycle cationique et le groupe hétérocyclique cationiquement polymérisable est un groupe de la formule (I), (II) ou (III) : 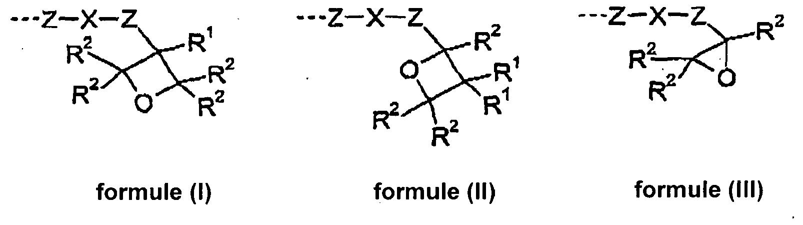 dans lesquelles
R¹ est, pour chaque occurrence, de manière identique ou différente, hydrogène, un groupe alkyle, alcoxy ou thioalcoxy en chaîne droite, ramifié ou cyclique comportant de 1 à 20 atomes de C, un système de cycle aromatique ou hétéroaromatique comportant de 4 à 24 atomes de cycle aromatique ou un groupe alkényle comportant de 2 à 10 atomes de C, où un ou plusieurs atomes d'hydrogène peuvent être remplacés par un halogène, tel que Cl ou F, ou CN et un ou plusieurs atomes de C non adjacents peuvent être remplacés par -O-, -S-, -CO-, -COO- ou -O-CO-; une pluralité de radicaux R¹ ici peuvent également former un système de cycle aliphatique ou aromatique mono- ou polycyclique les uns avec les autres ou avec R², R³ et/ou R⁴;
R² est, pour chaque occurrence, de manière identique ou différente, hydrogène, un groupe alkyle en chaîne droite, ramifié ou cyclique comportant de 1 à 20 atomes de C, un système de cycle aromatique ou hétéroaromatique comportant de 4 à 24 atomes de cycle aromatique ou un groupe alkényle comportant de 2 à 10 atomes de C, où un ou plusieurs atomes d'hydrogène peuvent être remplacés par un halogène, tel que Cl ou F, ou CN et un ou plusieurs atomes de C non adjacents peuvent être remplacés par -O-, -S-, -CO-, -COO- ou -O-CO-; une pluralité de radicaux R² ici peuvent également former un système de cycle aliphatique ou aromatique mono- ou polycyclique les uns avec les autres ou avec R¹, R³ et/ou R⁴;
X est, pour chaque occurrence, de manière identique ou différente, -O-, -S-, -CO-, -COO-, -O-CO- ou un groupe -CR³R⁴)ₙ-divalent ;
Z est, pour chaque occurrence, de manière identique ou différente , un groupe -(CR³R⁴)ₙ- divalent ;
R³, R⁴ sont, pour chaque occurrence, de manière identique ou différente, hydrogène, un groupe alkyle, alcoxy ou thioalcoxy en chaîne droite, ramifié ou cyclique comportant de 1 à 20 atomes de C, un système de cycle aromatique ou hétéroaromatique comportant de 4 à 24 atomes de cycle aromatique ou un groupe alkényle comportant de 2 à 10 atomes de C, où un ou plusieurs atomes d'hydrogène peuvent également être remplacés par un halogène, tel que Cl ou F, ou CN ; deux radicaux R³ ou R⁴ ou plus ici peuvent également former un système de cycle l'un avec l'autre ou à titre d'alternative avec R¹ ou R² ;
n est, pour chaque occurrence, de manière identique ou différente, un entier entre 0 et 20 ; sous la réserve que le nombre de ces groupes de la formule (I) ou de la formule (II) ou de la formule (III) soit limité par le nombre maximum d'atomes de H disponibles, c'est-à-dire substituables.

2. Dispositif électronique selon la revendication 1, **caractérisé en ce qu'**il s'agit d'une diode émettrice de lumière organique ou polymérique (OLED, PLED), d'une cellule solaire organique (O-SC), d'un transistor à effet de champ organique (O-FET), d'un circuit intégré organique (O-IC), d'un dispositif à pincement de champ organique (O-FQD), d'un amplificateur optique organique au d'une diode laser organique (O-laser).

3. Dispositif électronique selon une ou plusieurs des revendications 1 à 2, **caractérisé en ce qu'**il comprend les éléments qui suivent : substrat, électrode (anode ou cathode), intercouche comprenant un polymère dopé conducteur, couche tampon de conduction ou de semiconduction, organique, cationiquement réticulable, couche semiconductrice organique et countre-électrode (cathode ou anode).

4. Dispositif électronique selon une ou plusieurs des revendications 1 à 3, **caractérisé en ce qu'**une intercouche en un matériau présentant une constante diélectrique élevée est introduite entre une cathode métallique et le semiconducteur organique.

5. Dispositif électronique selon une ou plusieurs des revendications 1 à 4, **caractérisé en ce que** l'anode utilisée comprend des matériaux présentant un potentiel supérieur à 4,5 eV versus le vide.

6. Dispositif électronique selon une ou plusieurs des revendications 1 à 5, **caractérisé en ce que** le polymère conducteur dopé présente une conductivité >10⁻⁸ S/cm et un potentiel de 4 - 6 eV versus le vide.

7. Dispositif électronique selon la revendication 6, **caractérisé en ce que** le polymère conducteur utilisé comprend des dérivés de polythiophène ou de polyaniline et le dopage est mis en oeuvre au moyen d'acides de Brönsted polymère-liés.

8. Dispositif électronique selon une ou plusieurs des revendications 1 à 7, **caractérisé en ce que** le semiconducteur organique utilisé comprend des matériaux de semiconduction de poids moléculaire faible, oligomériques, dendritiques ou polymériques.

9. Dispositif électronique selon la revendication 8, **caractérisé en ce que** le semiconducteur organique est un polymère conjugué.

10. Dispositif électronique selon la revendication 8 et/ou 9, **caractérisé en ce que** le semiconducteur organique est un composé cationiquement réticulable.

11. Dispositif électronique selon une ou plusieurs des revendications 1 à 10, **caractérisé en ce que** la couche tampon organique est de poids moléculaire faible, oligomérique, dendritique ou polymérique.

12. Dispositif électronique selon une ou plusieurs des revendications 1 à 11, **caractérisé en ce que** l'épaisseur de couche de la couche tampon est dans la plage 5 - 300 nm.

13. Dispositif électronique selon une ou plusieurs des revendications 1 à 12, **caractérisé en ce que** le potentiel de la couche tampon est entre le potentiel du polymère conducteur dopé et celui du semiconducteur organique.

14. Dispositif électronique selon une ou plusieurs des revendications 1 à 13, **caractérisé en ce que** des matériaux de conduction de trous cationiquement réticulables sont utilisés pour la couche tampon.

15. Dispositif électronique selon la revendication 14, **caractérisé en ce que** des matériaux cationiquement réticulables basés sur triarylamine, basés sur thiophène ou basés sur triarylphosphine sont utilisés pour la couche tampon.
